# EUROPEAN PATENT APPLICATION

(11) **EP 2 086 033 A1**
(43) Date of publication of application: **05.08.2009**
(21) Application number: 08101176.9
(22) Date of filing: 31.01.2008
(51) Int. Cl.: H01L 51/00

(54) **Method of coating a substrate and coating installation**

(71) Applicant: Applied Materials, Inc., Santa Clara, CA 95054 (US)
(72) Inventor: König, Michael, 60529, Frankfurt am Main (DE); Michael, Klaus, 63571, Gelnhausen (DE); Bangert, Stefan, 36396, Steinau (DE); Hoffmann, Uwe, 63755, Alzenau (DE); Landgraf, Heike, 63486, Bruchköbel (DE)
(74) Representative: Lermer, Christoph

(57) **Abstract**

A method according to the invention comprises the step of providing a large-area substrate 1 and a first semiconductor, metal, or TCO (Transparent Conductive Oxide) layer 2 deposited on a surface of the substrate 1 (Fig. 1a). In the next process step illustrated in Fig. 1b a patterned mask layer 3 is printed on top of the first layer 2. The mask layer 3 consists of a phase-change material, e.g. wax, which may be deposited in an inkjet printing method. The phase-change material 3 has the ability to change in phase from a liquid to a solid state upon contact with the substrate 1. In a third process step a second semiconductor, metal, TCO (Transparent Conductive Oxide) layer 4 is deposited on top of the mask layer 3 and on the first layer 2 where the first layer 2 is not protected by the phase-change masking material 3. Afterwards, in a process step indicated in Fig. 1d the phase-change material 3 is removed. The second patterned layer structure 5 is arranged on top of the first layer 2 in the areas that had not been protected by the phase-change material. The method is proposed particularly for providing a first electrode of an organic electronic device.

## Description

### TECHNICAL FIELD

The present invention relates to a method of coating a substrate, comprising the steps of: a) providing a substrate having at least one surface to be coated; and b) depositing a shadow mask on said at least one surface of said substrate by using a printing method. Furthermore, the invention relates to a coating installation comprising: a printing tool for printing a shadow mask on a surface of a substrate; and a process chamber for arranging said substrate having said printed shadow mask deposited on said surface in said process chamber.

### BACKGROUND OF THE INVENTION

Large-area electronic devices usually include an optoelectronic layer for emitting light, e.g. an organic light emitting layer and one or a plurality of layers forming electrodes. An example for a large-area electronic device is an organic electronic device or an OLED (organic light emitting diode) display.

In order to control the light emission of the single display pixels, the electrode covering the entire area of the display is patterned. Usually, shadow masks are used for patterning the layers forming a first electrode of an organic electronic device, or photolithographic methods are applied. However, the use of shadow masks is expensive and the quality of the pattern decreases with an increasing number of coating processes due to the deposition of coating material on the shadow mask. Therefore, the shadow mask has to be cleaned and exchanged intermittently. Photolithographic procedures, on the other hand, require a lot of equipment and a plurality of process steps and thus involve high costs.

Consequently, efforts have been made to provide processes of manufacturing a structured or patterned electrode which still have a high throughput, but are more cost-efficient than conventional processes.

One of these methods is disclosed in document EP 1 251 398 A2, wherein a phase-change masking material is deposited on a surface of a substrate. Subsequently, the substrate or the thin film is etched resulting in a removal of material not protected by the phase-change masking material. After the etching step the masking material is removed.

The publication "Printing Methods and Materials for Large-Area Electronic Devices", Proceedings of the IEEE, Vol. 93, No.8, August 2005 by Chabincy, M. L., et al., refers to printing methods for the fabrication of active matrix thin-film transistor backplanes, wherein a printer is used to deposit all the materials of a circuit in a desired pattern directly. Alternatively, direct writing of a resist is disclosed in order to form a patterned etch mask.

### OBJECT OF THE INVENTION

It is an object of the present invention to propose a coating method and a coating installation for depositing a patterned electrode of a large-area electronic device on a substrate, wherein the method and installation result in a reduced number of process steps and have a high throughput.

### TECHNICAL SOLUTION

This object is achieved by the provision of a coating method according to claim 1 and a coating installation according to claim 11. The dependent claims contain features of preferred embodiments of the invention.

A method of coating a substrate comprises the steps of: a) providing a substrate having at least one surface to be coated; and b) depositing a patterned mask layer on said at least one surface of said substrate by using a printing method. The method is characterized by a further process step c) of depositing a layer of coating material on said surface of said substrate having said patterned mask deposited thereon.

The new idea in the method according to the invention is to provide a coating in a vacuum atmosphere after the shadow mask has been deposited on the substrate. The coating material is a semiconductor material or a TCO (Transparent Conductive Oxide) layer, e.g. an ITO coating material, or a metal layer, and may be deposited particularly by using evaporation or sputtering in a vacuum atmosphere.

The present invention provides a more simple process and thus a reduction of costs of a patterning process in the production of electrodes of OLED devices for the emission of light. The method provides for a reduction of the number of process steps. Furthermore, it is not necessary to use shadow masks for providing a patterned electrode layer on a substrate.

In a preferred embodiment of the invention the coating material deposited on said surface of said substrate in said step c) comprises a material including a semiconductor material, a metal material, and/or a TCO (Transparent Conductive Oxide; e.g. ITO - Indium Tin Oxide) material.

Said step c) of depositing a layer of coating material on the surface of the substrate may include depositing a layer comprising one or a stack of layers including a semiconductor layer, a metal layer, and/or a TCO (Transparent Conductive Oxide) layer. The layers of the stack of layers may be regarded as sub-layers of the layer deposited a on the surface of the substrate.

It is preferred that said step c) of depositing a layer of coating material on said surface of said substrate includes using a sputtering method, an evaporation method, a plasma coating method, a CVD method, and/or a PVD method.

Particularly, the method of coating a substrate is carried out for providing a patterned electrode of an LED (light emitting diode) display, particularly of an organic electronic device, on said substrate.

In a preferred embodiment of the invention said method step a) comprises a step of depositing a first layer of coating material on said at least one surface to be coated. Said first layer of coating material may be a semiconductor material layer, a metal layer, and/or a TCO (Transparent Conductive Oxide; e.g. ITO - Indium Tin Oxide) coating material layer. The same or a different material may be used to deposit the first layer and the layer of coating material deposited in process step c).

In another embodiment of the invention the method comprises a step of providing an optoelectronic device layer for the emission of light on said substrate.

In another embodiment of the invention said process step b) comprises using a printing method selected from inkjet printing, screen printing, porous printing, pad printing, etc. The most suitable printing method may be selected for a particular application.

It is preferred that said method step b) includes printing a phase-change material, e.g. wax, and/or a lift-off material on said surface in order to form said patterned mask. A phase-change material has the ability to change in phase from a liquid to a solid state upon contact with the substrate. The mask layer forms an inverse pattern of the structure to be deposited. The structure may be any structure, e.g. a line- and/or grid-like structure, a structure having covered areas and non-covered areas. The covered areas may be separated from each other, i.e. they may be printed without establishing any connections between the covered areas. In other words, the covered areas may form "islands" on top of the surface. The mask layer may be deposited in a protective atmosphere, e.g. in an inert gas atmosphere, or in a vacuum atmosphere. The printing device for providing the phase-change material layer may be integrated in a process chamber, wherein other coating processes may be carried out, or in a chamber separate from the coating chamber.

In a preferred embodiment of the invention said method includes a further process step d) removing said mask material from said substrate. This material must have the property to be easily removable from the surface of the substrate. In the end the second patterned semiconductor material, metal, and/or TCO (Transparent Conductive Oxide) layer structure (step c) is arranged on top of the first layer (step a) in the areas that had not been protected by the phase-change material.

The object of the invention is also achieved by the provision of a coating installation comprising: a printing tool for printing a patterned mask on a surface of a substrate; and a process chamber for arranging said substrate having said printed patterned mask deposited on the surface thereof in said process chamber. Furthermore, the coating installation comprises coating tools provided in said process chamber for depositing a coating layer on said surface of said substrate arranged in said process chamber; wherein said coating tools comprise a coating material source providing said coating material to be deposited on said surface of said substrate.

In a preferred embodiment said coating material source is a semiconductor, a metal, a TCO (Transparent Conductive Oxide), and/or an ITO (indium tin oxide) material source.

In another preferred embodiment of the invention said coating tools comprise sputter coating equipment, evaporation equipment, CVD coating equipment and/or PVD coating equipment.

Said printing tool for printing said patterned mask may include an inkjet printer, a screen printer, and/or a pad printing equipment.

Particularly, said coating equipment further comprises tools for removing said shadow mask material from said surface of said substrate.

Said coating equipment may include a further coating station comprising coating tools for depositing an LED (light emitting diode) layer system on said substrate, particularly a layer system of an organic electronic device.

Particularly, said coating equipment further comprises tools for removing said patterned mask material from said surface of said substrate

The features described above are meant to be protected by themselves or in any combination with the described method and/or device features.

### BRIEF DESCRIPTION OF THE DRAWINGS

Further objects and advantages result from the following description of specific embodiments. The figures show:
- Fig. 1a to 1d: a first embodiment of a method according to the present invention; and
- Fig. 2a to 2c: a second embodiment of a method according to the present invention.

### DESCRIPTION OF SPECIFIC EMBODIMENTS

The embodiments disclosed in this application refer to methods of depositing a patterned first electrode of an organic electronic device on a substrate. The substrate on which the electrode is deposited may be the carrier of the layer system deposited thereon. It may or may not comprise e. g. one or a plurality of light emitting layers, functional and/or protective layers, barrier layers, etc. The light emitting layer or layer stack may be deposited on top of the patterned first electrode.

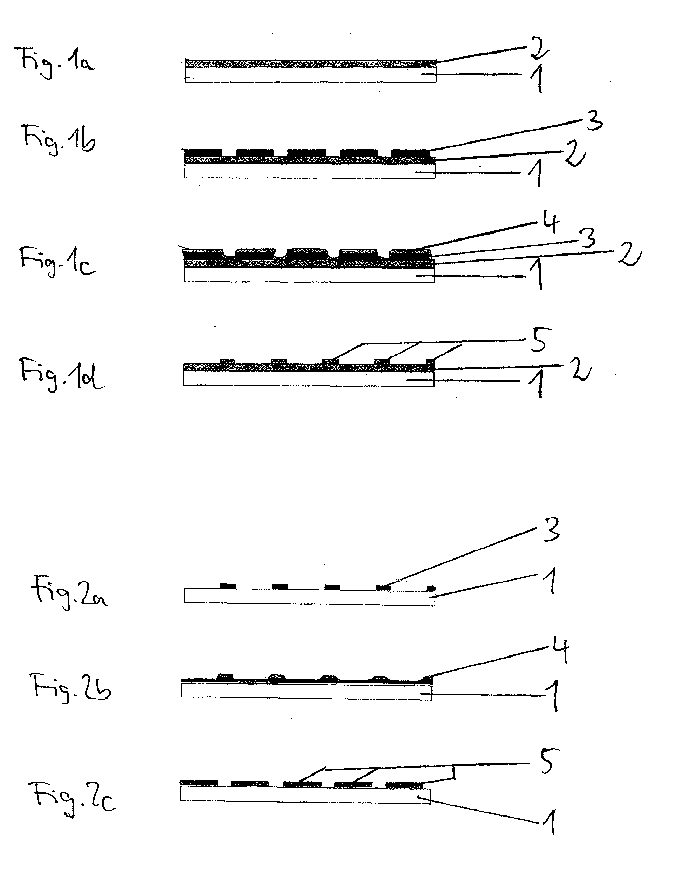

In the first embodiment of the invention the method comprises providing a large-area substrate 1 and depositing a first semiconductor, metal, or TCO (Transparent Conductive Oxide) layer 2 (or a combination of a plurality of layers including one or more of said materials) on a surface of the substrate 1 as illustrated in Fig. 1a. The layer 2 is deposited e.g. by an evaporation or sputtering method in a vacuum atmosphere.

In a second process step illustrated in Fig. 1b a patterned mask layer 3 is printed on top of the first layer 2. The mask layer 3 consists of a phase-change material, e.g. wax, which may be deposited in an inkjet printing method. The phase-change material has the ability to change in phase from a liquid to a solid state upon contact with the substrate 1. The wax layer 3 forms an inverse pattern of the structure to be deposited. The structure may be any structure, e.g. a line- and/or grid-like structure, a structure having covered areas and non-covered areas. The structure improves the current distribution in an organic electronic device. The coated areas provide lines of increased current flow rates.

In a third process step (Fig. 1c) a second semiconductor, metal, and/or TCO (Transparent Conductive Oxide; e.g. ITO - Indium Tin Oxide) layer 4 is deposited on top of the mask layer 3 and on top of the first layer 2 where the first layer is not protected by the phase-change masking material 3. The second material is deposited e.g. by an evaporation or sputtering method in a vacuum atmosphere. The second layer 4 may be of the same material or a material different from the first layer 2. Instead of a single second layer 4, a layer system 4 of two or a plurality of layers comprising one or a plurality of semiconductor layers, metal layers, and/or TCO (Transparent Conductive Oxide) layers may be deposited in the step illustrated in Fig. 1c.

Afterwards, in a process step indicated in Fig. 1d the phase-change material 3 is removed from the first layer 2. A second patterned semiconductor, metal, or TCO (Transparent Conductive Oxide, e.g. ITO - Indium Tin Oxide) layer structure 5 is left on top of the first layer 2 in the areas that had not been covered by the phase-change material. The result is a patterned/structured semiconductor, metal, or TCO (Transparent Conductive Oxide) layer 5.

Another embodiment of the invention is illustrated in Figs. 2a to 2c.

In a first step a substrate 1 is provided, and a layer of a phase-change material 3 is deposited directly on the surface of the substrate 1. The phase-change material 3 is deposited by using an inkjet printing method. The phase-change material layer 3 is patterned to form a structure on the surface of the substrate 1 which is inverse to the line- and/or grid-like structure of an electrode of an organic electronic device to be formed.

Afterwards, in a subsequent process step illustrated in Fig. 2b the first layer 4 is deposited on top of the phase-change material layer 3 and, where the surface of the substrate 1 is not protected by the phase-change material, directly on the surface of the substrate1. Instead of a single first layer 4, a layer system 4 of two or a plurality of layers comprising one or a plurality of semiconductor layers, metal layers, and/or TCO (Transparent Conductive Oxide) layers may be deposited in the step illustrated in Fig. 2b.

Afterwards, the phase-change material 3 and the metal material 4 deposited on top of the phase-change material 3 are removed from the substrate 1. Thereby, a patterned semiconductor, metal, or TCO (Transparent Conductive Oxide) layer 5 (line- or grid-like) is left directly on the surface of the substrate 1 forming a first electrode of an organic electronic device.

In this way the number of process steps may be reduced. Furthermore, it is not necessary to use a shadow mask for providing a patterned electrode layer on a substrate.

## Claims

1. A method of coating a substrate (1), comprising the steps of: a) providing a substrate (1) having at least one surface to be coated; and b) depositing a patterned mask layer (3) on said at least one surface of said substrate (1) by using a printing method,
**characterized by**
a further process step c) of depositing a layer (4) of coating material on said surface of said substrate (1) having said patterned mask layer (3) deposited thereon.

2. The method of coating a substrate according to claim 1,
**characterized in that**
said layer of coating material (4) deposited on said surface of said substrate (1) in step c) comprises a material including a semiconductor material, a metal material, and/or a TCO (Transparent Conductive Oxide) material.

3. The method of coating a substrate (1) according to claim 1 or 2,
**characterized in that**
said step c) of depositing a layer (4) of coating material on said surface of said substrate (1) includes depositing a layer (4) comprising one or a stack of layers including a semiconductor layer, a metal layer, and/or a TCO (Transparent Conductive Oxide) layer.

4. The method of coating a substrate (1) according to any of the previous claims,
**characterized in that**
said step c) of depositing a layer of coating material (4) on said surface of said substrate includes using a sputtering method, an evaporation method, a plasma coating method, a CVD method, and/or a PVD method.

5. The method of coating a substrate (1) according to any of the previous claims,
**characterized in that**
said method is carried out for providing a patterned electrode of an organic electronic device on said substrate (1).

6. The method of coating a substrate (1) according to any of the previous claims,
**characterized in that**
said method step a) comprises a step of depositing a first layer (2) of coating material on said at least one surface of the substrate (1) to be coated.

7. The method of coating a substrate (1) according to any of the previous claims,
**characterized in that**
said method comprises a step of providing an optoelectronic device layer for the emission of light on said substrate.

8. The method of coating a substrate (1) according to any of the previous claims,
**characterized in that**
said process step b) comprises using a printing method selected from inkjet printing, screen printing, porous printing, pad printing, etc, or a combination of such printing methods.

9. The method of coating a substrate (1) according to any of the previous claims,
**characterized in that**
said method step b) includes printing a phase-change material and/or a lift-off material on said surface in order to form said patterned mask (3).

10. The method of coating a substrate (1) according to any of the previous claims,
**characterized in that**
said method includes a further process step d) of removing said mask material (3) from said substrate (1).

11. A coating installation comprising:
a printing tool for printing a patterned mask (3) on a surface of a substrate; and
a process chamber for arranging said substrate (1) having said patterned mask deposited on the surface thereof in said process chamber;
**characterized in that**
said coating installation further comprises coating tools provided in said process chamber for depositing a coating layer (4) on said surface of said substrate (1) arranged in said process chamber; wherein said coating tools comprise a coating material source providing said coating material (4) to be deposited on said surface of said substrate (1).

12. The coating installation according to claim 11,
**characterized in that**
said coating material source is a metal material source and/or a semiconductor material, a metal, and/or a TCO (Transparent Conductive Oxide) material source.

13. The coating installation according to claim 11 or 12,
**characterized in that**
said coating tools comprise sputter coating equipment, evaporation equipment, CVD coating equipment and/or PVD coating equipment.

14. The coating installation according to any of the previous claims 11 to 13,
**characterized in that**
said printing tool for printing said patterned mask (3) includes an inkjet printer, a screen printer, and/or a pad printing equipment.

15. The coating installation according to any of the previous claims 11 to 14,
**characterized in that**
said coating equipment includes a further coating station comprising coating tools for depositing an organic electronic device on said substrate (1), particularly comprising a layer system including at least an organic material layer.

16. The coating installation according to any of the previous claims 11 to 15,
**characterized in that**
said coating equipment further comprises tools for removing said patterned mask material (3) from said surface of said substrate (1).
